# EUROPÄISCHE PATENTSCHRIFT

(11) **EP 1 969 644 B1**
(45) Veröffentlichungstag und Bekanntmachung des Hinweises auf die Patenterteilung: **20.06.2012**
(21) Anmeldenummer: 06805994.8
(22) Anmeldetag: 02.10.2006
(51) Int. Cl.: H01L 31/0288, H01L 31/0352, H01L 31/18

(54) **VERFAHREN ZUR HERSTELLUNG EINER SOLARZELLE ODER EINES STRAHLUNGSDETERKTORS UND SOLARZELLE ODER STRAHLUNGSDETEKTOR**
METHOD FOR MANUFACTURING A SOLAR CELL OR A RADIATION DETECTOR, AND SOLAR CELL OR RADIATION DETECTOR
PROCÉDÉ DE FABRICATION D'UNE CELLULE SOLAIRE OU D'UN DÉTECTEUR DE RAYONNEMENT ET CELLULE SOLAIRE OU DÉTECTEUR DE RAYONNEMENT AINSI OBTENUE

(30) Priorität: 23.12.2005 DE 102005061820
(43) Veröffentlichungstag der Anmeldung: 17.09.2008
(73) Patentinhaber: Infineon Technologies Austria AG, 9500 Villach (AT)
(72) Erfinder: SCHULZE, Hans-Joachim, 85521 Ottobrunn (DE)
(74) Vertreter: Bickel, Michael
(86) Internationale Anmeldenummer: PCT/EP2006/009550
(87) Internationale Veröffentlichungsnummer: WO 2007/079795

(56) Entgegenhaltungen:
- DE-A1- 3 426 226
- DE-A1- 4 416 549
- GB-A- 1 552 907
- JP-A- 51 024 888
- JP-A- 63 143 876
- US-A- 5 290 367
- US-A- 5 797 998
- US-A1- 2002 058 353
- BARAKEL D ET AL: "n-p Junction formation in p-type silicon by hydrogen ion implantation" SOLAR ENERGY MATERIALS AND SOLAR CELLS, ELSEVIER SCIENCE PUBLISHERS, AMSTERDAM, NL, Bd. 72, Nr. 1-4, April 2002 (2002-04), Seiten 285-290, XP004339776 ISSN: 0927-0248
- KEEVERS M J ET AL: "Efficiency improvements of silicon solar cells by the impurity photovoltaic effect" PROCEEDINGS OF THE PHOTOVOLTAIC SPECIALISTS CONFERENCE. LOUISVILLE, MAY 10 - 14, 1993, NEW YORK, IEEE, US, Bd. CONF. 23, 10. Mai 1993 (1993-05-10), Seiten 140-146, XP010113289 ISBN: 0-7803-1220-1
- PEARSALL N M ET AL: "EFFECT OF ISOTROPIC PROTON IRRADIATION ON THE PERFORMANCE OF ITO/INP SOLAR CELLS" PHOTOVOLTAIC SPECIALISTS CONFERENCE. LAS VEGAS, SEPT. 26 - 30, 1988, NEW YORK, IEEE, US, Bd. VOL. 2 CONF. 20, 26. September 1988 (1988-09-26), Seiten 898-902, XP000167181

## Beschreibung

Die Erfindung betrifft ein Verfahren zur Herstellung einer Solarzelle und eine Solarzelle.

Solarzellen weisen bekanntlich einen Halbleiterkörper auf, in dem ein pn-Übergang zwischen einer n-dotierten Zone und einer p-dotierten Halbleiterzone gebildet ist. Durch Lichtabsorption, d.h. durch Photonen, die in den Halbleiterkörper eindringen, werden Ladungsträgerpaare (Elektronen-Loch-Paare) in dem Halbleiterkörper erzeugt, die durch eine Raumladungszone, die sich im Bereich dieses pn-Übergangs ausbildet, getrennt werden und die zu einem Stromfluss beitragen. Ladungsträgerpaare, die in dem Halbleiterkörper außerhalb dieser Raumladungszone des pn-Übergangs generiert werden, diffundieren in dem Halbleiterkörper in zufälliger Richtung bis sie in den Bereich der Raumladungszone gelangen und durch das dort vorhandene elektrische Feld getrennt werden oder bis sie durch Rekombination verloren gehen.

Die Rekombinationsrate ist dabei abhängig von der Diffusions-länge der Minoritätsladungsträger in dem Halbleiterkörper, also abhängig von der Diffusionslänge von Elektronen, wenn die Ladungsträgerpaare in der p-dotierten Zone der Solarzelle erzeugt werden, und abhängig von der Diffusionslänge von Löchern, wenn die Ladungsträgerpaare in der n-dotierten Zone der Solarzelle erzeugt werden. Diese Diffusionslänge ist abhängig von der Konzentration der in dem Kristall des Halbleiterkörpers vorhandenen Kristalldefekte, die als Rekombinationszentren wirken können und die damit die Diffusionslänge reduzieren. Zur Verringerung der Rekombinationsrate sind hohe Anforderungen an die Defektfreiheit bzw. die Kristallgüte des Halbleiterkristalls des Halbleiterkörpers zu stellen, die allerdings mit erhöhten Herstellungskosten verbunden sind.

Die DE 44 16 549 A1 beschreibt jeweils eine Solarzelle, bei der sich eine Vielzahl von Vertiefungen ausgehend von einer Seite in den Halbleiterkörper der Solarzelle hinein erstrecken. Im Bereich der Seitenwände dieser Gräben sind zur Realisierung von pn-Übergängen dotierte Bereiche vorhanden, die komplementär zu einer Grunddotierung des Halbleiterkörpers dotiert sind. Der Abstand der einzelnen Vertiefungen ist dabei kleiner oder gleich der Diffusionslänge. Bei diesem Bauelement ist der Abstand einzelner Bereiche des Halbleiterkörpers, in denen Ladungsträgerpaare erzeugt werden können, zu einem pn-Übergang reduziert, wodurch die Rekombinationswahrscheinlichkeit insgesamt reduziert ist.

Die Herstellung dieser Solarzelle ist wegen der notwendigen Herstellung von Vertiefungen allerdings aufwendig. Darüber hinaus geht ein nicht unerheblicher Teil des Volumens des Halbleiterkörpers durch die Herstellung der Vertiefungen verloren, der dadurch nicht mehr für die Ladungsträgergeneration zur Verfügung steht.

Die US 3,682,708 beschreibt eine Solarzelle, bei der in vertikaler Richtung eines Halbleiterkörpers pn-Übergänge vorhanden sind. Diese pn-Übergänge sind durch eine Anzahl übereinander angeordneter p- und n-dotierter Halbleiterschichten gebildet, von denen jeweils zwei benachbarte Schichten komplementär zueinander dotiert sind. Die n-dotierten Schichten sind dabei durch n-dotierte Zonen, die sich durch die p-dotierten Schichten erstrecken, untereinander verbunden, und die p-dotierten Schichten sind dabei durch p-dotierte Zonen, die sich durch die n-dotierten Schichten erstrecken, untereinander verbunden. Das Verfahren zur Herstellung dieser Solarzelle erfordert die Abscheidung einer Anzahl komplementär zueinander dotierter Epitaxieschichten und ist damit sehr aufwendig.

Die DE 102 43 758 A1 beschreibt die Herstellung vergrabener n-dotierter Feldstoppzonen in einem n-dotierten Halbleiterkörper unter Verwendung einer Protonenimplantation und der nachfolgenden Durchführung eines Ausheilschrittes.

Die DE 34 26 226 A1 und US 5,290,367 beschreiben ein UVempfindliches Fotoelement bzw. eine Solarzelle, die jeweils oberflächennahe Halbleiterzonen aufweisen, die komplementär dotiert sind zu einer Grunddotierung eines Halbleiterkörpers.

Aufgabe der vorliegenden Erfindung ist es, ein Verfahren zur Herstellung einer Solarzelle mit reduzierter Rekombinationswahrscheinlichkeit und eine Solarzelle mit reduzierter Rekombinationswahrscheinlichkeit zur Verfügung zu stellen.

Diese Aufgabe wird durch eine Verfahren nach Anspruch 1 sowie durch eine Solarzelle oder Strahlungs detektor nach Anspruch 7 gelöst. Vorteilhafte Ausgestaltungen der Erfindung sind Gegenstand der Unteransprüche.

Das erfindungsgemäße Verfahren zur Herstellung einer Solarzelle oder Strahlungs detektor sieht vor, einen einkristallinen Halbleiterkörper bereitzustellen, der zwei gegenüberliegende Seiten und eine p-Grunddotierung aufweist, und eine Protonenimplantation durchzuführen, bei der Protonen über eine erste der Seiten derart in den Halbleiterkörper implantiert werden, dass eine Anzahl beabstandet zueinander angeordneter Defektbereiche entsteht, die sich ausgehend von der einen Seite in den Halbleiterkörper hineinerstrecken und in denen Kristalldefekte des Halbleiterkörpers und implantierte Protonen vorhanden sind. An diese Protonenimplantation schließt sich ein Ausheilschritt an, bei dem der Halbleiterkörper wenigstens im Bereich der Defektbereiche aufgeheizt wird und dessen Temperatur und Dauer derart gewählt sind, dass aus den Kristalldefekten und den Protonen wasserstoffinduzierte Donatoren entstehen, um dadurch eine Anzahl beabstandet zueinander angeordneter n-dotierter Halbleiterzonen zu erzeugen. Das Verfahren sieht außerdem vor, einen n-dotierten Emitter zu erzeugen, an den sich die n-dotierten Halbleiterzonen anschließen und der höher als die n-dotierten Halbleiter zonen dotiert ist im Bereich der ersten Seite. Die Erzeugung dieses n-dotierten Emitters kann dabei vor der Herstellung oder nach der Herstellung der n-dotierten Halbleiterzonen erfolgen, vorzugsweise erfolgt die Herstellung dieses n-Emitters jedoch vorher.

Die Herstellung der Defektbereiche setzt eine selektive Protonenimplantation, d.h. eine Protonenimplantation in vorgegebene Bereiche des Halbleiterkörpers voraus. Diese Selektivität kann durch Anwendung einer Maske erfolgen, die solche Bereiche abdeckt, in die nicht implantiert werden soll. Alternativ besteht auch die Möglichkeit, ein "Protonenschreibverfahren" einzusetzen, bei dem ein Protonenstrahl gezielt auf solche Bereich gelenkt werden kann, in die implantiert werden soll.

Die Herstellung der Defektbereiche bzw. der aus diesen Defektbereichen resultierenden n-dotierten Halbleiterzonen erfolgt vorzugsweise derart, dass ein gegenseitiger Abstand zweier solcher n-dotierter Halbleiterzonen kleiner ist als die Diffusionslänge von Minoritätsladungsträgern in den die Grunddotierung aufweisenden Abschnitten des Halbleiterkörpers. Solche die Grunddotierung aufweisende Abschnitte des Halbleiterkörpers befinden sich jeweils zwischen zwei benachbart zueinander angeordneten n-dotierten Halbleiterzonen.

Ist der n-dotierte Emitter im Bereich der ersten Seite des Halbleiterkörpers angeordnet, bilden die sich ausgehend von der einen Seite in den Halbleiterkörper hinein erstreckenden n-dotierten Halbleiterzonen eine kammförmige bzw. fingerförmige Struktur um Bereiche des Halbleiterkörpers, die die p-Grunddotierung aufweisen. Die Rekombinationswahrscheinlichkeit ist bei einer aus dem erfindungsgemäßen Verfahren resultierenden Solarzelle aufgrund des kammförmigen oder fingerförmigen Verlaufs des pn-Übergangs in dem Halbleiterkörper im Vergleich zu Solarzellen ohne eine solche Kamm- oder Fingerstruktur reduziert. Auf die Erzeugung von Gräben zur Herstellung der in der Tiefe des Halbleiterkörpers angeordneten Abschnitte der n-dotierten Halbleiterzonen kann bei dem erfindungsgemäßen Verfahren verzichtet werden, so dass die n-dotierten Halbleiterzonen in lateraler Richtung des Halbleiterkörpers auf sehr platzsparende Weise und auch auf sehr reproduzierbare Weise und sehr gut kontrollierbare Weise und extrem dicht beieinander liegend realisiert werden können. Im Vergleich zu herkömmlichen Solarzellen mit Gräben ist die Fläche des pn-Übergangs bei einer durch das erfindungsgemäße Verfahren hergestellten Solarzelle bezogen auf ein gegebenes Volumen des Halbleiterkörpers deutlich erhöht, woraus eine höhere Stromausbeute einer mit dem erfindungsgemäßen Verfahren hergestellten Solarzelle resultiert.

Bei einer Abwandlung des zuvor erläuterten Verfahrens ist vorgesehen, wenigstens eine vergrabene n-dotierte Halbleiterzone mittels Protonenimplantation und einem anschließenden Ausheilschritt herzustellen, die beabstandet zu einer ersten Seite des Halbleiterkörpers angeordnet ist. Bei diesem Verfahren werden außerdem ein n-dotierter Emitter und eine n-dotierte Verbindungszone hergestellt. Die n-dotierte Verbindungszone verbindet die vergrabenen n-dotierten Halbleiterzonen miteinander und schließt diese an den n-dotierten Emitter an. Hierbei besteht insbesondere die Möglichkeit, die Verbindungszone und den n-Emitter als gemeinsame Halbleiterzone zu realisieren.

Die erfindungsgemäße Solarzelle umfasst einen Halbleiterkörper mit einer ersten und einer zweiten Seite, der eine Grunddotierung eines ersten Leitungstyps aufweist, eine erste Emitterzone, die vorzugsweise im Bereich der ersten Seite des Halbleiterkörpers angeordnet ist und die mit Dotierstoffen eines zu dem ersten Leitungstyp komplementären Leitungstyps dotiert ist. Die Solarzelle umfasst außerdem mehrere Halbleiterzonen des zweiten Leitungstyps, die in einer lateralen Richtung des Halbleiterkörpers beabstandet zueinander angeordnet sind und die sich wenigstens teilweise in einer vertikalen Richtung in dem Halbleiterkörper erstrecken und die sich an die erste Emitterzone anschließen. Diese Halbleiterzonen des zweiten Leitungstyps sind als durchgehende Zonen ausgebildet, die jeweils in lateraler Richtung zwischen zwei die Grunddotierung des Halbleiterkörpers aufweisenden Abschnitten angeordnet sind. Die Halbleiterzonen des zweiten Leitungstyps sind insbesondere n-dotierte Halbleiterzonen, die wasserstoffinduzierte Donatoren aufweisen.

Die vorliegende Erfindung wird nachfolgend anhand von Figuren näher erläutert.
- Figur 1: veranschaulicht ein erfindungsgemäßes Verfahren zur Herstellung einer Solarzelle anhand von Querschnitten durch einen Halbleiterkörper während verschiedener Verfahrensschritte.
- Figur 2: zeigt einen Querschnitt durch eine Solarzelle, die durch ein gegenüber Figur 1 abgewandeltes Verfahren hergestellt wurde.
- Figur 3: zeigt eine Solarzelle, die durch ein weiteres gegenüber Figur 1 abgewandeltes Verfahren hergestellt wurde.
- Figur 4: zeigt eine weitere Solarzelle, die durch ein erfindungsgemäßes Verfahren hergestellt wurde.
- Figur 5: zeigt eine Abwandlung der Solarzelle gemäß Figur 3.
- Figur 6: veranschaulicht ein weiteres erfindungsgemäßes Verfahren zur Herstellung einer Solarzelle anhand von Querschnitten durch einen Halbleiterkörper während verschiedener Verfahrensschritte.
- Figur 7: zeigt eine Abwandlung der in Figur 6D dargestellten Solarzelle.
- Figur 8: zeigt Querschnitte durch eine Solarzelle, die mittels eines gegenüber dem Verfahren nach Figur 6 abgewandelten Verfahren hergestellt wurde.
- Figur 9: zeigt einen Querschnitt durch eine Solarzelle, die mittels eines gegenüber dem Verfahren nach Figur 6 abgewandelten Verfahren hergestellt wurde.

In den Figuren bezeichnen, sofern nicht anders angegeben, gleiche Bezugszeichen gleiche Bauelementbereiche mit gleicher Bedeutung.

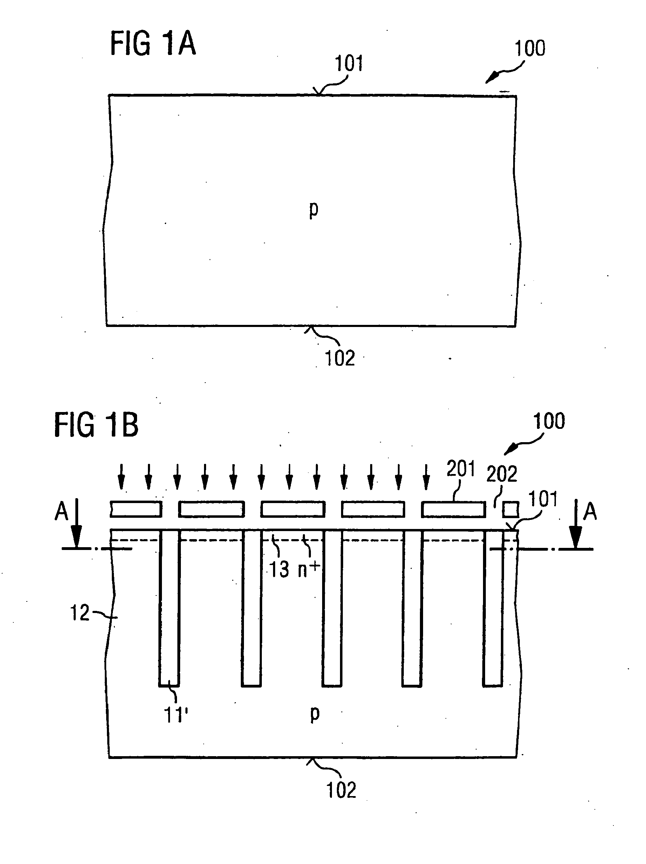

Ein erstes erfindungsgemäßes Verfahren zur Herstellung einer Solarzelle wird nachfolgend anhand der Figuren 1A bis 1F erläutert.

Bezug nehmend auf Figur 1A umfasst das Verfahren das Bereitstellen eines einkristallinen Halbleiterkörpers 100 der eine p-Grunddotierung aufweist. Der Halbleiterkörper 100 besitzt zwei gegenüberliegende Seiten, die nachfolgend als erste und zweite Seiten 101, 102 des Halbleiterkörpers 100 bezeichnet werden. Die Dicke des Halbleiterkörpers 100 in vertikaler Richtung liegt beispielsweise im Bereich von 400 µm.

Bezug nehmend auf Figur 1B werden unter Verwendung einer Maske 201 anschließend Protonen über die erste Seite 101 in den Halbleiterkörper implantiert. Die Maske 201 ist beispielsweise eine Metallmaske, die Aussparungen 202 aufweist, über welche die Protonen in den Halbleiterkörper 100 implantiert werden. Diese Maske kann während des Implantationsschrittes beabstandet zu der ersten Seite 101 des Halbleiterkörpers angeordnet sein, kann jedoch auch während des Implantationsschrittes auf der ersten Seite 101 des Halbleiterkörpers aufliegen bzw. dort aufgebracht sein (nicht dargestellt).

Vor Durchführung der Protonenbestrahlung kann im Bereich der Vorderseite 101 ein hoch-n-dotierter Emitter 13 hergestellt werden, der in Figur 1B gestrichelt dargestellt ist, und der nachfolgend noch erläutert werden wird.

Die Protonenimplantation führt dazu, dass in dem Halbleiterkörper 100 unterhalb der Bereiche, die durch die Maske 201 nicht abgedeckt sind, durch die Protonenimplantation Kristalldefekte, wie beispielsweise Doppelleerstellen, in dem Halbleiterkristall des Halbleiterkörpers 100 hervorgerufen werden. Bereiche 11' des Halbleiterkörpers, in denen solche Kristalldefekte erzeugt werden, werden nachfolgend als Defektbereiche bezeichnet. Die Abmessungen dieser Defektbereiche 11' in lateraler Richtung des Halbleiterkörpers 100 sind durch die Abmessungen der Aussparungen 202 der Maske 201 vorgegeben.

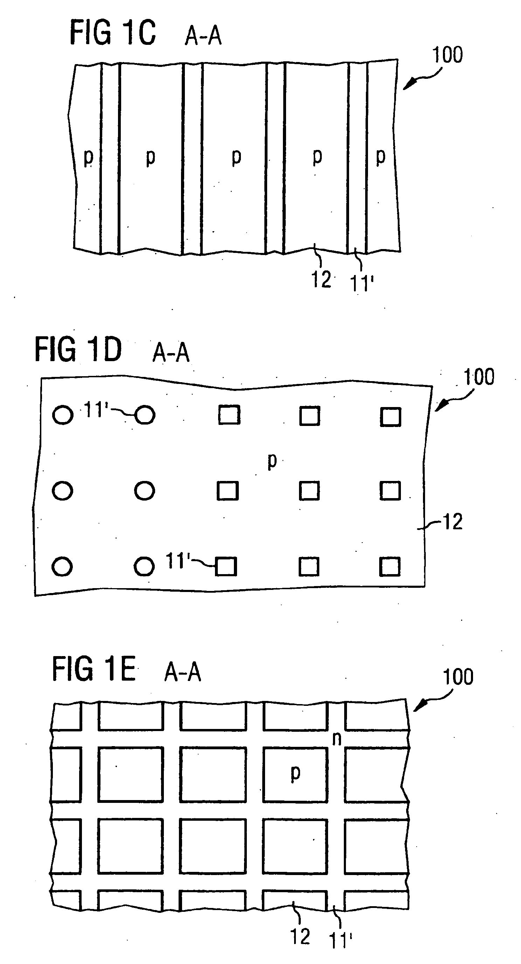

Die Aussparungen 202 der Maske sind beispielsweise schlitzförmig ausgestaltet, wodurch in Draufsicht betrachtet mehrere streifenförmige, jeweils parallel zueinander verlaufende Defektbereiche entstehen, wie dies in Figur 1C dargestellt ist, die einen Querschnitt durch den Halbleiterkörper in der in Figur 1B dargestellten Schnittebene A-A zeigt.

Alternativ besteht auch die Möglichkeit, die Aussparungen der Maske so zu realisieren, dass säulenförmige Defektbereiche 11' entstehen, wie dies im Ergebnis In Figur 1D dargestellt ist. Die Aussparungen der Maske - und damit die Geometrie der späteren Defektbereiche - können dabei insbesondere eine kreisförmige, eine quadratische oder beliebige mehreckige Geometrie haben.

Bezugnehmend auf Figur 1E, besteht außerdem die Möglichkeit, die Defektbereiche 11' so zu erzeugen, dass sie in einer parallel zu der ersten und zweiten Seite 101, 102 verlaufenden Schnittebene gitterförmig ausgebildet sind. Figur 1E zeigt ein Beispiel mit quadratischen Gitterzwischenräumen. Selbstverständlich sind jedoch gitterförmig angeordnete Defektbereiche mit beliebigen Geometrien der Gitterzwischenräume anwendbar.

Die Tiefe der Defektbereiche 11', d. h. deren Ausdehnung in vertikaler Richtung des Halbleiterkörpers 100 ausgehend von der ersten Seite 101, ist abhängig von der Implantationsenergie, mit der die Protonen in den Halbleiterkörper implantiert werden. Die Defektbereiche 11' werden vorzugsweise.so erzeugt, dass deren Tiefe ausgehend von der ersten Seite 101 einem Wert entspricht, der mindestens der Summe aus der Eindringtiefe des bei Betrieb der Solarzelle über die erste Seite 101 eingestrahlten Lichts und der Diffusionslänge der Minoritätsladungsträger entspricht. Vorzugsweise beträgt die Tiefe der Defektbereiche mindestens das Doppelte dieser Summe.

Die Protonen, die in den Halbleiterkörper implantiert werden, lagern sich größtenteils im sogenannten End-Of-Range-Bereich der Protonenimplantation an, während sich die Defekte über den gesamten durch die Protonen durchstrahlten Bereich erstrecken. Um eine gleichmäßigere Protonenverteilung - und damit eine gleichmäßigere spätere Dotierung - innerhalb des Defektbereiches 11' zu erreichen, besteht die Möglichkeit mehrere Implantationsschritte mit unterschiedlichen Implantationsenergien durchzuführen. Die Implantationsenergien liegen erfindungsgemäβß im Bereiche zwischen 0,5 MeV und 10 MeV.

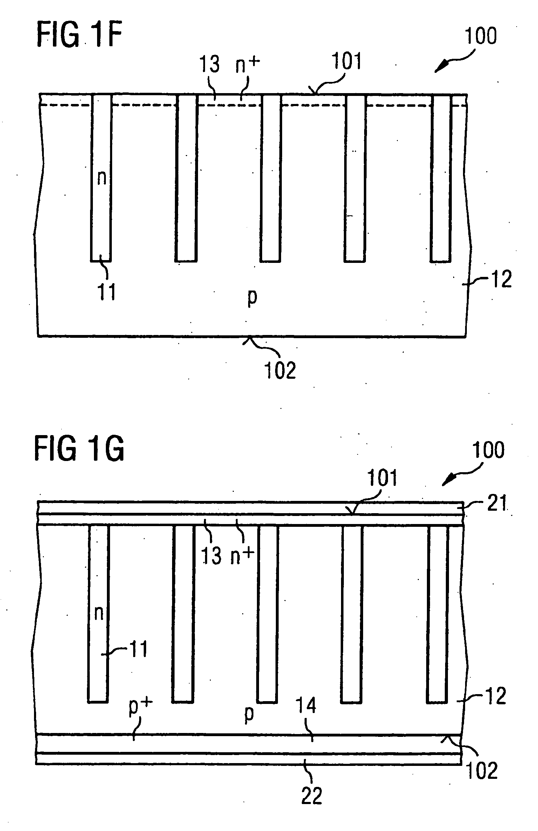

An die Protonenimplantation schließt sich ein Ausheilschritt an, bei dem der Halbleiterkörper wenigstens im Bereich der Defektbereiche 11' aufgeheizt wird und dessen Temperatur und Dauer so gewählt sind, dass aus den durch die Protonenimplantation hervorgerufenen Kristalldefekten und den implantierten Protonen n-dotierende Komplexe, sogenannte wasserstoffinduzierte Donatoren, entstehen. Die Defektbereiche 11' (Figur 1B) werden so in eine Anzahl beabstandet zueinander angeordneter n-dotierter Halbleiterzonen 11 umgewandelt, die sich ausgehend von der ersten Seite 101 in vertikaler Richtung in den Halbleiterkörper 100 hineinerstrecken. Figur 1F zeigt den Halbleiterkörper 100 nach Durchführung dieses Ausheilschrittes.

Die Temperatur während des Ausheilschrittes liegt zwischen 250° C und 550° C, vorzugsweise zwischen 400° C und 500° C. Die Dauer des Ausheilschrittes liegt zwischen 30 Minuten und 10 Stunden, vorzugsweise zwischen 2 und 5 Stunden.

Die Temperaturen während des Ausheilschrittes sind vörzugsweise so gewählt, dass in Richtung der ersten Seite 101 eine Diffusion der Protonen innerhalb der Defektbereiche erfolgen kann, wodurch die Dotierung nicht auf den End-Of-Range-Bereich der Bestrahlung beschränkt ist. Hierdurch kann sich bei geeigneter Wahl der Ausheiltemperatur, z.B. 500° C, und der Ausheildauer, z.B. einige Stunden, in vertikaler Richtung des Halbleiterkörpers 100 über weite Bereiche ein annähernd homogenes Dotierprofil in den protonenbestrahlten Defektbereichen ausbilden, ohne dass eine Vielzahl von Implantationsschritten mit unterschiedlichen Implantationsenergien erforderlich ist, d.h. vorzugsweise ist eine Implantationsenergie ausreichend. Die resultierende Dotierung ist hierbei umso homogener je länger die Ausheildauer ist.

Ein positiver Effekt einer Ausheilung bei Temperaturen oberhalb von 450° C besteht darin, dass durch die Bestrahlung hervorgerufene rekombinationswirksame Defekte - wie z.B. Doppelleerstellen oder Leeerstellen-Sauerstoff-Komplexe - bei diesen Temperaturen weitgehend ausgeheilt werden, wodurch die durch die Bestrahlung zunächst abgesenkte Diffusionslänge in den protonenbestrahlten Gebieten wieder zunimmt.

Die Abmessungen der n-dotierten Halbleiterzonen 11 entsprechen damit weitgehend den Abmessungen der Defektbereiche 11, die über die Abmessungen der Maskenaussparungen 202 und die Implantationsenergie einstellbar sind. Da die Abmessungen der n-dotierten Halbleiterzonen 11 aus den erläuterten Gründen in horizontaler Richtung des Halbleiterkörpers vergleichsweise exakt einstellbar sind, und da sich Donatoren nur dort bilden, wo sowohl bestrahlungsbedingte Defekte als auch Wasserstoffatome vorhanden sind, wodurch die Grenzen der n-dotierten Gebiete 11 immer weitgehend parallel zu der Bestrahlungsrichtung verlaufen und deren laterale Ausdehnung während der Temperung nicht zunimmt, besteht mittels des erfindungsgemäßen Verfahrens die Möglichkeit, sehr schmale n-dotierte Halbleiterzonen 11 mit geringem gegenseitigen Abstand herzustellen, um dadurch innerhalb des Volumens des Halbleiterkörpers 11 eine große Fläche des pn-Übergangs zwischen den n-dotierten Halbleiterzonen 11 und den die Grunddotierung des Halbleiterkörpers aufweisenden Bereichen 12 zu erreichen, und insbesondere die Entfernung, die durch Licht erzeugte freie Ladungsträger in der Solarzelle zurücklegen müssen bis sie eine Raumladungszone erreichen, zu minimieren.

Die p-Grunddotierung des Halbleiterkörpers 100 liegt beispielsweise im Bereich zwischen 10¹⁵ cm⁻³ und 10¹⁶ cm⁻³. Die Dotierungskonzentration der n-dotierten Halbleiterzonen 11 ist abhängig von der Implantationsdosis, mit welcher die Protonen in den Halbleiterkörper implantiert werden. Diese Implantationsdosis ist beispielsweise so gewählt, dass die n-Dotierung dieser Halbleiterzonen 11 zwischen 2·10¹⁵ cm⁻³ und 2·10¹⁶ cm⁻³ liegt, woraus eine n-Nettodotierung dieser Halbleiterzonen 11 zwischen 10¹⁵ cm⁻³ und 10¹⁶ cm⁻³ resultiert.

Die Solarzelle wird Bezug nehmend auf Figur 1G vervollständigt durch einen n-dotierten Emitter 13, an den sich die n-dotierten Halbleiterzonen 11 anschließen und der in dem Beispiel im Bereich der Vorderseite 101 angeordnet ist. Die Herstellung dieser n-dotierten Emitterzone 13 kann in bekannter Weise beispielsweise durch Eindiffusion von n-Dotierstoffatomen über die erste Seite 101 erfolgen. Die Dotierungskonzentration dieses n-dotierten Emitters 13 ist höher als die der n-dotierten Halbleiterzonen 11 und liegt beispielsweise im Bereich von 8·10¹⁹ cm⁻³. Der n-Emitter 11 kann außer durch eine Eindiffusion von n-Dotierstoffatomen auch durch eine Implantation von Dotierstoffatomen und einen nachfolgenden Temperschritt zur Aktivierung und gegebenenfalls Eindiffusion der implantierten Dotierstoffe erfolgen. Sowohl bei einem Diffusionsverfahren als auch bei einem Implantationsverfahren zur Herstellung des n-Emitters 13 können Temperaturen auftreten, die höher sind als die während des Ausheilschrittes zur Herstellung der n-Halbleiterzonen 11 angewendeten Temperaturen. Um negative Auswirkungen dieser höheren Temperaturen auf dien-Halbleiterzonen 11 - insbesondere eine Degradierung der n-dotierenden Komplexe - zu vermeiden, erfolgt die Herstellung des n-Emitters 13 wie bereits im Zusammenhang mit Figur 1A erläutert, vor Herstellung der n-Halbleiterzonen 11. Die zuvor anhand von Figur 1B erläuterte Protonenimplantation erfolgt dann durch die bereits im Bereich der ersten Seite 101 hergestellte n-Emitterzone 13 hindurch.

Der n-Emitter 13 wird durch eine Anschlusselektrode 21, die beispielsweise aus einem Metall besteht, kontaktiert. Diese Anschlusselektrode 21 wird nach Herstellung des n-Emitters 13 auf die erste Seite 101 des Halbleiterkörpers 100 aufgebracht. Wenn der n-Emitter 13 vor der Durchführung der Protonenbestrahlung hergestellt wird, kann die Herstellung der Anschlusselektrode 21 sowohl vor der Protonenbestrahlung als auch nach der Protonenbestrahlung erfolgen. Im ersten Fall erfolgt die Protonenbestrahlung dann (nicht näher dargestellt) maskiert durch die Maske 201 und durch die Metallisierung der Anschlusselektrode hindurch.

Im Bereich der der ersten Seite 101 gegenüberliegenden zweiten Seite 102 wird vorzugsweise ein p-dotierter Emitter 14 hergestellt, der durch eine weitere Anschlusselektrode 22 kontaktierbar ist. Dieser p-Emitter 14 dient im Wesentlichen dazu, einen ohmschen Kontakt zwischen der Anschlusselektrode 22 und den die p-Grunddotierung aufweisenden Bereichen 12 des Halbleiterkörpers 100 herzustellen. Die Herstellung des p-Emitters 14 kann entsprechend des n-Emitters 13 durch Eindiffusion oder durch Implantation von p-Dotierstoffatomen über die zweite Seite 102 des Halbleiterkörpers 100 erfolgen. Die Dotierungskonzentration im Bereich des p-Emitters 14 liegt beispielsweise zwischen einigen 10¹⁶ cm⁻³ und 10¹⁹ cm⁻³. Die Herstellung des p-Emitters 14 kann in nacht näher dargestellter Weise vor der Herstellung der n-dotierten Halbleiterzonen 11 erfolgen, kann aber auch nach der Herstellung dieser n-Zonen erfolgen. Voraussetzung für die Herstellung des p-Emitters 14 nach Herstellung der n-Zonen 11 ist, dass Aktivierungs- oder Ausheiltemperaturen, auf welche der Halbleiterkörper 100 bei Herstellung des p-Emitters aufgeheizt wird, unterhalb von ca. 550° C liegen. Andernfalls, d.h. bei Temperaturen oberhalb 550° C, würden die durch die Protonenbestrahlung und den Ausheilschritt erzeugten n-dotierenden Komplexe der n-Zonen 11 aufgelöst.

Die mittels des erfindungsgemäßen Verfahrens hergestellte Solarzelle mit dem im Bereich der ersten Seite 101 angeordneten n-Emitter 13 und den sich ausgehend von diesem n-Emitter 13 in vertikaler Richtung in den Halbleiterkörper 100 hineinerstreckenden n-dotierten Halbleiterzonen 11 weist innerhalb des Volumens des Halbleiterkörpers 100 einen großflächigen pn-Übergang und damit bei einer gegebenen Lichteinstrahlung eine hohe Stromergiebigkeit auf. Die Lichteinstrahlung in die Solarzelle erfolgt vorzugsweise über die erste Seite 101, wobei sowohl die Anschlusselektrode 21 als auch der n-Emitter 13 so dimensioniert sind, dass Photonen in die die Grunddotierung aufweisenden Abschnitte 12 des Halbleiterkörpers 100 gelangen können und dort Elektronen-Loch-Paare erzeugen können. Diese Elektronen-Loch-Paare diffundieren in beliebige Richtungen innerhalb des Halbleiterkörpers 100. Die n-dotierten Halbleiterzonen 11 werden vorzugsweise so hergestellt, dass der gegenseitige Abstand zweier solcher Zonen 11 geringer ist, als die Diffusionslänge von Minoritätsladungsträgern, im vorliegenden Fall Elektronen, innerhalb der die Grunddotierung aufweisenden Bereiche 12 des Halbleiterkörpers 100. Besonders bevorzugt ist der gegenseitige Abstand zweier solcher Zonen 11 kleiner oder gleich der 0,25-fachen Diffusionslänge der Minoritätsladungsträger, d.h. typische Abstände liegen im Bereich von weniger als 100 µm bei Verwendung von Silizium. Die Wahrscheinlichkeit für ein Elektronen-Loch-Paar in das elektrische Feld einer sich am pn-Übergang ausbildenden Raumladungszone (nicht dargestellt) zu gelangen, ist gegenüber Solarzellen ohne solche sich in vertikaler Richtung erstreckende Halbleiterzonen 11 dadurch erhöht, wodurch die Rekombinationswahrscheinlichkeit bei der nach dem erfindungsgemäßen Verfahren hergestellten Solarzelle verringert ist.

Das erfindungsgemäße Verfahren ermöglicht die Herstellung n-dotierter Halbleiterzonen 11 mit geringen Abmessungen in horizontaler Richtung, es ermöglicht insbesondere die Herstellung in horizontaler Richtung des Halbleiterkörpers durchgehender n-dotierter Halbleiterzonen 11 mit in horizontaler Richtung geringen Abmessungen. Hieraus resultiert bezogen auf ein gegebenes Volumen des Halbleiterkörpers 100 eine im Vergleich zu bisherigen Solarzellen vergrößerte Fläche des pn-Übergangs und eine geringere Entfernung, die durch Licht erzeugte freie Ladungsträger in der Solarzelle zurücklegen müssen bis sie eine Raumladungszone erreichen, und dadurch eine erhöhte Stromergiebigkeit und somit eine erhöhte Effizienz der Solarzelle.

Das erfindungsgemäße Verfahren eignet sich insbesondere zur Herstellung einer Solarzelle, bei der der sogenannte "Impurity Photovoltaic Effect (IPV)" zur Erhöhung der Effizienz der Solarzelle genutzt wird. Bei solchen Solarzellen werden zusätzliche Energieniveaus für die Erzeugung von Ladungsträgerpaaren geschaffen, indem geeignete Störstellen in das Kristallgitter des Halbleiterkörpers eingebracht werden. Durch die Störstellen wird eine Mehrfachstufenanregung ermöglicht, was gleichbedeutend damit ist, dass Photonen, deren Energie geringer ist als der Bandabstand des verwendeten Halbleitermaterials - üblicherweise Silizium - zur Erzeugung von Ladungsträgerpaaren beitragen können. Diese Photonen würden andernfalls ungenutzt transmittiert und nicht zur Stromerzeugung beitragen. Die definiert eingebrachten Störstelle wirken allerdings auch als Rekombinationszentren, die zu einer Erhöhung der Rekombinationswahrscheinlichkeit führen. Dieser erhöhten Rekombinationswahrscheinlichkeit wirkt hingegen der geringe Abstand der n-dotierten Zonen 11 entgegen. Bei einem ausreichend geringen Abstand der n-Zonen 11 können mehrere geeignete Energieniveaus innerhalb der Bandlücke des verwendeten Halbleitermaterials erzeugt werden, um somit die Effizienz der Solarzelle weiter zu steigern.

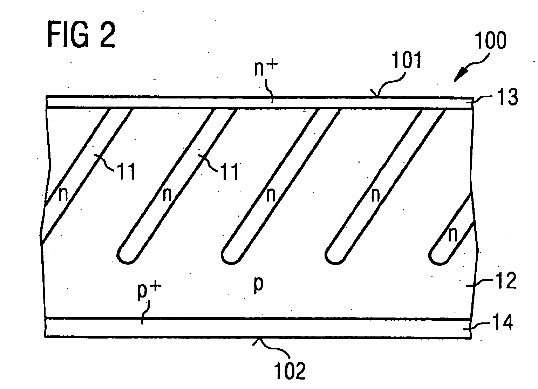

Bezug nehmend auf Figur 2, die eine weitere nach dem erfindungsgemäßen Verfahren hergestellte Solarzelle zeigt, besteht auch die Möglichkeit, die n-dotierten Halbleiterzonen 11 so zu erzeugen, dass sich diese unter einem Winkel α ungleich 90° bezogen auf die erste Seite 101 in den Halbleiterkörper 100 hineinerstrecken. Die Herstellung solcher schräg verlaufender n-dotierter Halbleiterzonen 11 kann dadurch erfolgen, dass die anhand von Figur 1B erläuterte Protonenimplantation derart erfolgt, dass die Protonen nicht senkrecht sondern unter dem Winkel α über die erste Seite 101 in den Halbleiterkörper implantiert werden.

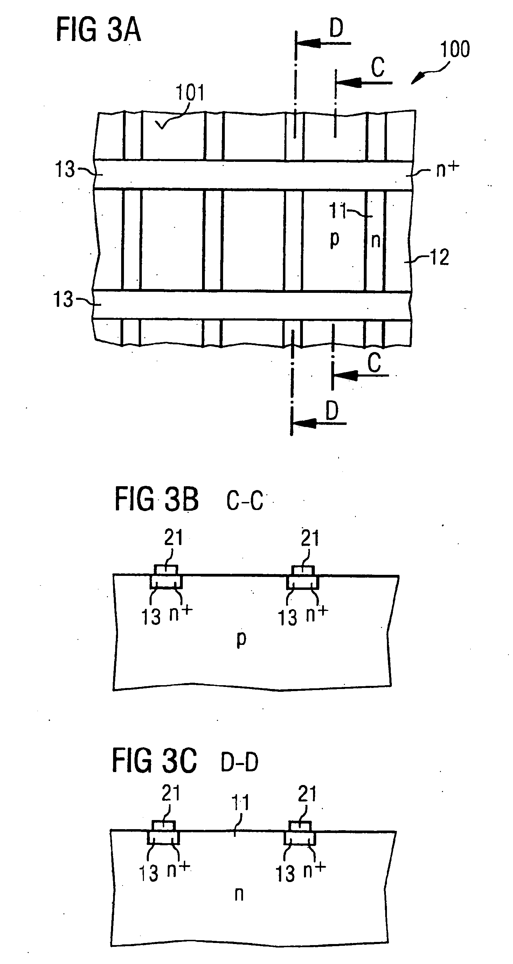

Figur 3 zeigt ein weiteres Ausführungsbeispiel einer durch das erfindungsgemäße Verfahren hergestellten Solarzelle. Figur 3A zeigt dabei eine ausschnittsweise eine Draufsicht auf die erste 101 des Halbleiterkörpers 100, die Figuren 3B und 3C zeigen Querschnitte in den in Figur 3A dargestellten Schnittebenen C-C und D-D.

Bei diesem Bauelement sind die n-dotierten Halbleiterzonen 11, die sich in den Halbleiterkörper 100 ausgehend von der ersten Seite 101 hinein erstrecken, als parallel zueinander verlaufende Zonen ausgebildet. Die Herstellung solcher Zonen 11 erfolgt beispielsweise unter Anwendung des unter Bezugnahme auf Figur 1C erläuterten Verfahrens. Der n-Emitter 13 ist bei diesem Bauelement im Bereich der ersten Seite 101 angeordnet und durch eine oder durch mehrere parallel verlaufende streifenförmig ausgebildete stark n-dotierte Halbleiterzonen gebildet. Der n-Emitter verläuft in horizontaler Richtung senkrecht zu den n-Halbleiterzonen 11 und kontaktiert dadurch diese n-Halbleiterzonen 11. Bedingt durch die streifenförmige Realisierung reichen Abschnitte 12 des Halbleiterkörpers 100, die die p-Grunddotierung aufweisen bis an die Vorderseite des Halbleiterkörpers 100.

Die Geometrie der den n-Emitter 13 kontaktierenden Anschlusselektrode 21 ist an die Geometrie des n-Emitters 13 angepasst, so dass die Bereiche der Vorderseite 101, in denen die p-Zonen 12 bis an die Vorderseite 101 reichen, nicht von der Anschlusselektrode 21 überdeckt sind. Dies erleichtert den Lichteinfall in den Bereichen, die nicht von der Anschlusselektrode 21 überdeckt sind. In diesem Zusammenhang sei darauf hingewiesen, dass der Halbleiterkörper 100 der fertiggestellten Solarzelle von einer Passivierungsschicht umgeben sein kann, die aus Gründen der Übersichtlichkeit jedoch nicht dargestellt ist.

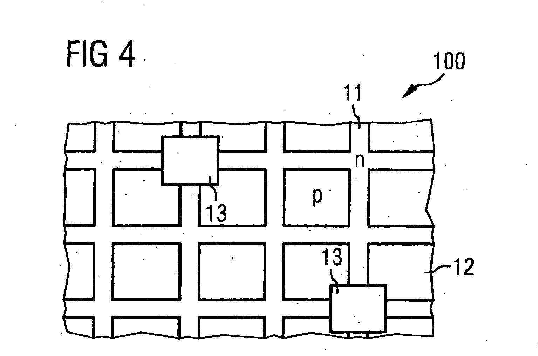

Die zuvor erläuterte Realisierung eines die n-Halbleiterzonen 11 nur abschnittsweise kontaktierenden n-Emitters ist auch bei n-Halbleiterzonen, die eine gitterförmige Struktur bilden und deren Herstellung anhand von Figur 1E erläutert wurde, anwendbar. Da die n-Halbleiterzonen 11 in diesem Fall ein zusammenhängendes n-Gebiet bilden, kann der n-Emitter in diesem Fall "inselförmig" realisiert sein, der die n-Zonen nur an einigen Stellen kontaktiert. Figur 4 zeigt eine solche Solarzelle mit einem inselartigen n-Emitter 13 in Draufsicht. Der n-Emitter 13 kann aber auch sowohl bei der streifenförmigen als auch bei der gitterförmigen Struktur der n-Zonen 11 oberflächennah in den Bereichen angeordnet sein, in denen die n-Zonen 11 an die Halbleiteroberfläche angrenzen, d.h. in diesem Fall weist der n-Emitter 13 im wesentlichen dasselbe Design in lateraler Richtung wie die n-Zonen 11 auf.

Der n-Emitter 13 hat bei allen zuvor erläuterten Ausführungsbeispielen insbesondere die Aufgabe, für einen niedrigen Kontaktwiderstand zwischen den die Elektronen in der Solarzelle aufnehmenden n-Halbleiterzonen 11 und der Anschlusselektrode 21 zu sorgen. Bei Realisierungsformen, bei denen mehrere beabstandet zueinander angeordnete n-Halbleiterzonen vorhanden sind, dient der Emitter außerdem als "Verbindungszone" zwischen den einzelnen n-Zonen 11.

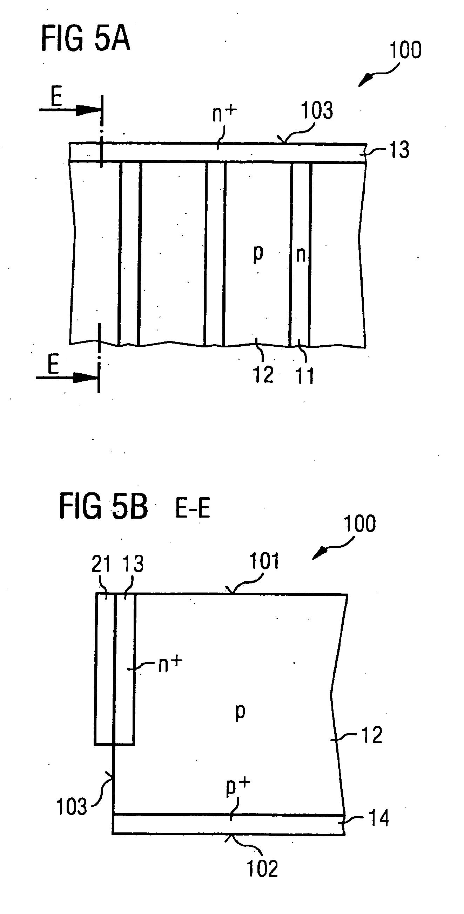

Figur 5 zeigt ein weiteres Ausführungsbeispiel einer durch das erfindungsgemäße Verfahren hergestellten Solarzelle. Die n-Halbleiterzonen 11 sind bei diesem Bauelement streifenförmig ausgebildet und reichen bis zu einer senkrecht zu der ersten und zweiten Seite 101, 102 verlaufenden Randseite 103 des Halbleiterkörpers 100. Der n-Emitter 13 ist bei diesem Bauelement im Bereich dieser Randseite angeordnet, endet in vertikaler Richtung jedoch oberhalb des p-Emitters 14. Der n-Emitter 13 erfüllt bei diesem Bauelement die Funktion ebenfalls die Funktion einer die einzelnen n-Halbleiterzonen verbindenden und an die Anschlusselektrode 21 anschließenden Verbindungszone. Die Anschlusselektrode 21 kann dabei auf die Randseite 103 aufgebracht sein, kann jedoch auch so angeordnet sein, dass sie den n-Emitter an der ersten Seite kontaktiert (nicht dargestellt).

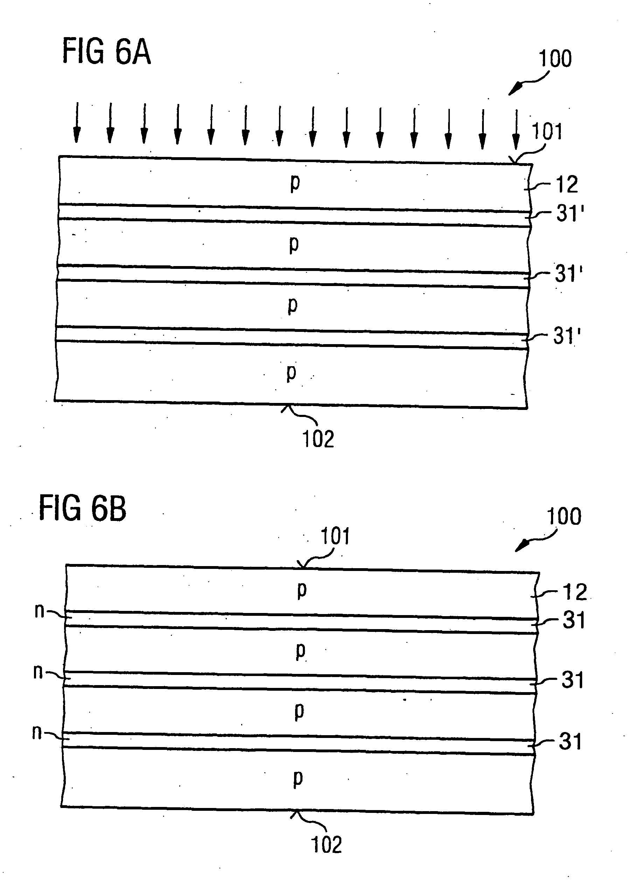

Anhand der Figuren 6A bis 6D wird nachfolgend ein weiteres erfindungsgemäßes Verfahren zur Herstellung einer Solarzelle mit einer Anzahl beabstandet zueinander angeordneter n-dotierter Halbleiterzonen erläutert.

Bezug nehmend auf Figur 6A werden bei diesem Verfahren Protonen unter Anwendung unterschiedlicher Implantationsenergien unmaskiert über die erste Seite 101 in den Halbleiterkörper 100 implantiert. Mit dem Bezugszeichen 31' sind in Figur 3A die End-Of-Range-Bereiche dieser Protonenimplantation bezeichnet, also die Defektbereiche, in denen durch die Bestrahlung hervorgerufene Kristalldefekte in höchster Konzentration vorhanden sind und in denen die durch die Bestrahlung implantierten Protonen eingelagert sind. Der Abstand dieser Defektbereiche 31' zu der ersten Seite 101 des Halbleiterkörpers und der gegenseitige Abstand zweier solcher Defektbereiche 31' ist abhängig von der Implantationsenergie, mit der die Protonen in den Halbleiterkörper 100 implantiert werden.

An diese Protonenimplantation schließt sich ein Ausheilschritt an. Durch diesen Ausheilschritt werden wasserstoffinduzierte Donatoren in den Defektbereichen 31', in denen sowohl hochkonzentriert Kristalldefekte als auch Protonen vorhanden sind, gebildet und Kristalldefekte in den durch die Protonen durchstrahlten Bereichen, in denen sich jedoch keine oder nur relativ wenige Protonen eingelagert haben, werden weitgehend ausgeheilt. Durch diesen Ausheilschritt werden die Defektbereiche 31' in n-dotierte Halbleiterzonen 31, die parallel zu der ersten Seite 101 verlaufen, umgewandelt. Figur 6B zeigt den Halbleiterkörper 100 nach Durchführung dieses Ausheilschrittes. Bei diesem Verfahren dürfen sich die n-dotierten Zonen 31 in vertikaler Richtung nicht so weit ausdehnen, dass sie zusammenwachsen, da sonst die p-dotierten Zwischenzonen 12 verschwinden würden. Die Ausdehnung der n-dotierten Zonen 31 in vertikaler Richtung des Halbleiterkörpers 100 kann über die Dauer und die Temperatur des Ausheilschrittes eingestellt werden. Die Temperatur und/oder die Dauer des Ausheilschrittes sind dabei vorzugsweise so gewählt, dass sie deutlich kleiner bzw. deutlich kürzer sind als bei dem anhand von Figur 1 erläuterten Verfahren, bei dem eine möglichst homogen dotierte vertikale n-Zone 11 - idealerweise unter Verwendung nur eines Implantationsschrittes mit einer Implantationsenergie - erreicht werden soll.

Für die Grunddotierung des Halbleiterkörpers 100 und die Dotierung der durch die Protonenimplantation und den anschließenden Ausheilschritt erzeugten n-dotierten Halbleiterzonen 31 gelten entsprechend die für das Verfahren gemäß Figur 1 gemachten Angaben.

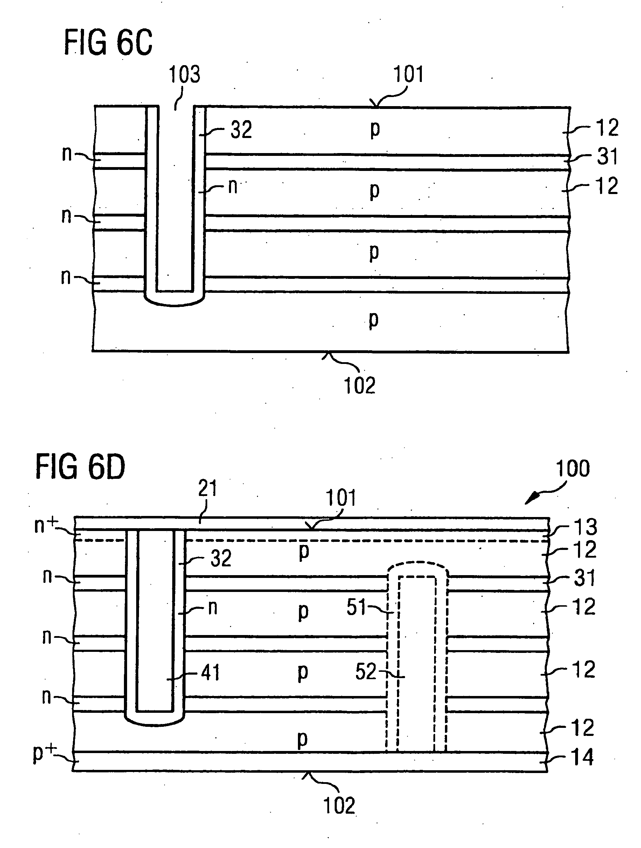

Die Herstellung der Solarzelle umfasst bezugnehmend auf Figur 6C außer der Herstellung der n-dotierten Halbleiterzonen 31, die jeweils beabstandet zu der ersten Seite 101 angeordnet sind und die im Wesentlichen parallel zu dieser ersten Seite 101 verlaufen, die Herstellung wenigstens einer n-dotierten Verbindungszone 32, die die einzelnen vergrabenen n-Halbleiterzonen 31 miteinander verbindet. Diese Verbindungszone 32 kann vor der Herstellung der n-Zonen 31 oder - wie nachfolgend erläutert - auch nach der Herstellung der n-Zonen 31 erfolgen. Die Möglichkeit einer Herstellung der Verbindungszone 31 nach Herstellung der n-Zonen 31 ist maßgeblich davon abhängig, welche Temperaturen zur Herstellung der Verbindungszone 31 erforderlich sind. Liegen diese Temperaturen oberhalb von 550° C, bei denen sich die n-dotierenden Komplexe der n-Zonen 31 auflösen würden, ist eine Herstellung der Verbindungszone 31 vor der Herstellung der n-Zonen 31 erforderlich.

Die Herstellung dieser Verbindungszone 32 erfolgt Bezug nehmend auf Figur 6C beispielsweise durch Herstellen eines sich ausgehend von der ersten Seite 101 in vertikaler Richtung in den Halbleiterkörper 100 hineinerstreckenden Graben. An die Herstellung dieses Grabens 103 schließt sich die Herstellung einer n-dotierten Halbleiterzone 32 im Bereich von Seitenwänden des Grabens an. Die Herstellung dieser n-dotierten Zone 32 kann durch Eindiffusion von n-Dotierstoffatomen oder durch Implantation von n-Dotierstoffatomen und einen nachfolgenden Ausheilschritt folgen. Die Herstellung des Grabens 103 erfolgt derart, dass dieser in vertikaler Richtung bis an die unterste, d. h. die am weitesten zu der ersten Seite 101 beabstandet angeordnete, vergrabene n-Halbleiterzone 31 reicht. Der Graben 102 kann nach Abschluss des Dotierverfahrens mit einem Füllmaterial aufgefüllt werden, das elektrisch isolierend oder elektrisch leitend sein kann. Da bei dieser Variante Ausheilungs- bzw. Diffusionstemperatluren eingesetzt werden, die deutlich oberhalb von 550° C liegen, ist dieses Verfahren zur Herstellung einer Verbindungszone vor der Herstellung der n-Halbleiterzonen 31 durchzuführen.

Die Solarzelle wird vervollständigt durch eine im Bereich der ersten Seite 101 angeordnete n-dotierte Emitterzone 13 (gestrichelt dargestellt) sowie optional durch eine im Bereich der zweiten Seite 102 angeordnete p-dotierte Emitterzone 14. Für die Dotierungskonzentrationen dieser n- und p-Emitterzonen 13, 14 gelten die zuvor zu der Solarzelle gemäß Figur 1G gemachten Angaben entsprechend. Die vergrabenen n-dotierten Halbleiterzonen 31 sind über die weitere n-Halbleiterzone 32 an den n-Emitter 13 angeschlossen, der vorzugsweise vor der Herstellung der n-Zonen 31 hergestellt wird.

Die Herstellung des n-Emitters 13 im Bereich der Vorderseite 101 ist vorteilhaft, da Ladungsträgerpaare, die knapp unterhalb der ersten Seite erzeugt werden, unmittelbar durch die Raumladungszone getrennt werden, die sich an dem pn-Übergang zwischen dem n-Emitter 13 und den die Grunddotierung aufweisenden Abschnitten 12 des Halbleiterkörpers 100 ausbildet. Der n-Emitter wird bei dieser Ausführungsform durch eine auf die Vorderseite 101 aufgebrachte Anschlusselektrode 21 kontaktiert. Der n-Emitter 13 kann insbesondere streifenförmig ausgebildet sein, wie dies unter Bezugnahme auf Figur 3A erläutert wurde.

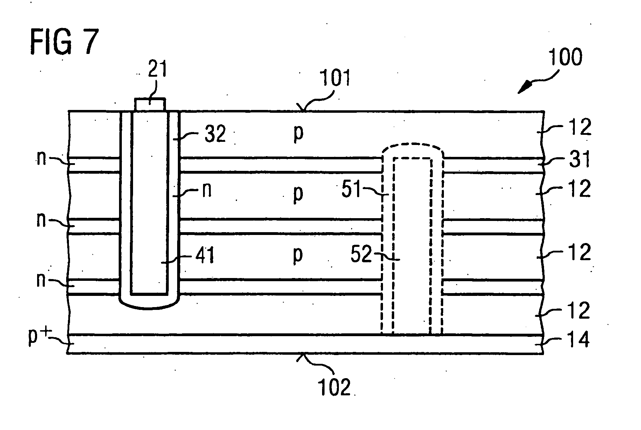

Auf die Herstellung eines solchen im Bereich der Vorderseite 101 des Halbleiterkörpers 100 angeordneten n-Emitters kann bezugnehmend auf Figur 7 verzichtet werden, wenn der zur Herstellung der Verbindungszone 32 hergestellte Graben nach Herstellung der Verbindungszone 32 mit einem elektrisch leitenden Material 41, beispielsweise hochdotiertes Polysilizium, aufgefüllt wird und wenn die Verbindungszone 32 so hochdotiert hergestellt wird, dass ein niedriger Kontaktwiderstand zwischen der Verbindungszone 41 und dem leitenden Füllmaterial vorhanden ist. Die Verbindungszone 32 bildet in diesem Fall gleichzeitig den n-Emitter der Solarzelle, der über das leitende Füllmaterial an die das Füllmaterial kontaktierende erste Anschlusselektrode angeschlossen ist.

Erfolgt die Protonenimplantation zur Herstellung..der n-Zonen 31 bei den anhand der Figuren 6 und 7 erläuterten Bauelementen ganzflächig über die erste Seite 101, so sind nach Durchführung des Ausheilschrittes durchgehende n-dotierte Zonen 31 vorhanden. Zwei in vertikaler Richtung benachbart zueinander angeordnete n-Zonen 31 schließen dann eine p-dotierte Zwischenzone ein, die ohne weitere Maßnahmen keine p-Verbindung zu dem p-Emitter 14 hätte.

Um die p-Zwischenzonen 12 miteinander zu verbinden und an den p-Emitter anzuschließen, kann entsprechend der Herstellung der n-Verbindungszone 32 eine p-Verbindungszone 51 hergestellt werden, die gestrichelt in den Figuren 6D und 7 eingezeichnet ist und die sich ausgehend von der zweiten Seite 102 in vertikaler Richtung in den Halbleiterkörper 100 hinein erstreckt. Die Herstellung dieser p-Verbindungszone 51 erfolgt beispielsweise durch Herstellen eines sich ausgehend von der zweiten Seite 102 in vertikaler Richtung in den Halbleiterkörper 100 hineinerstreckenden Graben. An die Herstellung dieses Grabens schließt sich die Herstellung der p-dotierten Verbindungszone 51 im Bereich von Seitenwänden des Grabens an. Die Herstellung dieser p-Verbindungszone 51 kann durch Eindiffusion von p-Dotierstoffatomen oder durch Implantation von p-Dotierstoffatomen und einen nachfolgenden Ausheilschritt folgen. Die Herstellung des Grabens erfolgt derart, dass dieser in vertikaler Richtung bis an die oberste, d. h. die am weitesten zu der zweiten Seite 102 beabstandet angeordnete, p-Zone 12 reicht. Der Graben kann nach Abschluss des Dotierverfahrens mit einem Füllmaterial aufgefüllt werden. Auch die Herstellung dieser p-Verbindungszone 51 sollte vor der Herstellung der n-Halbleiterzonen 31 erfolgen, wenn zur Herstellung der p-Verbindungszone 51 Temperaturen größer als 550 °C° erforderlich sind.

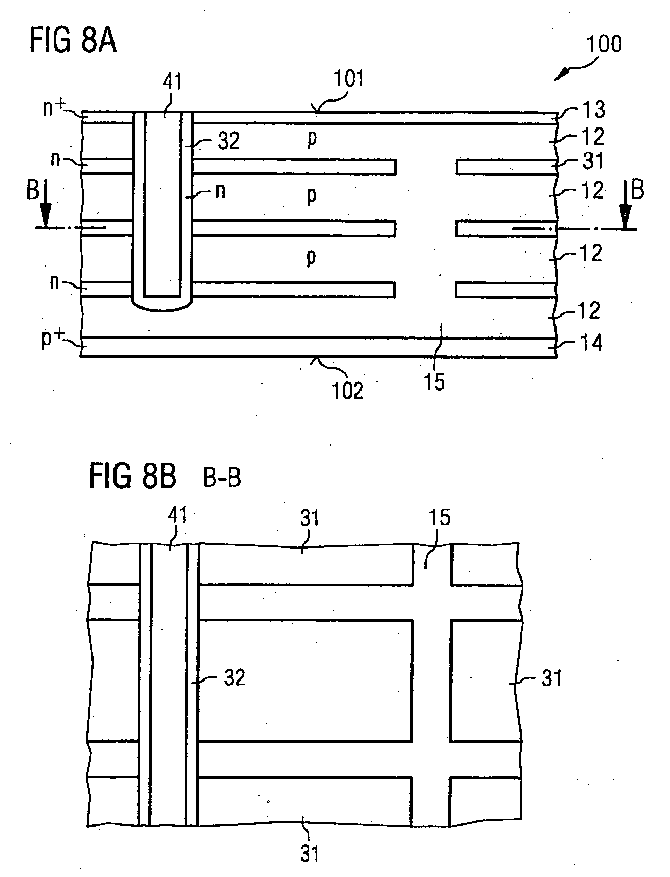

Auf die zuvor erläuterte vergleichsweise aufwendige Herstellung der p-Verbindungszone 51 kann verzichtet werden, wenn die Protonenimplantation zur Herstellung der Defektbereiche (31' in Figur 3A) derart maskiert erfolgt, dass einzelne Abschnitte des Halbleiterkörpers 100 von der Bestrahlung ausgespart werden. Bezugnehmend auf Figur 8A entsteht im Ergebnis dadurch eine Solarzelle, die in vertikaler Richtung durchgehendende p-dotierte Abschnitte 15 aufweist, in denen keine vergrabenen n-dotierten Halbleiterzonen vorhanden sind. Diese durchgehenden p-dotierten Zonen 15, die die p-Grunddotierung des Halbleiterkörpers 100 aufweisen und die ausgehend von den p-Emitter 14 in vertikaler Richtung des Halbleiterkörpers verlaufen, funktionieren als p-Verbindungszonen und ermöglichen einen Stromfluss, der aus der photoneninduzierten Ladungsträgergeneration resultiert, aus dem Volumen des Halbleiterkörpers 100 an den p-Emitter 14.

Bezugnehmend auf Figur 8B, die einen Querschnitt durch eine n-Zone 31 in einer in Figur 8A dargestellten Schnittebene B-B zeigt, erfolgt die Maskierung des Halbleiterkörpers 100 bei der Protonenbestrahlung beispielsweise derart, dass mehrere in lateraler Richtung beabstandet zueinander angeordnete n-Zonen 31 entstehen, wobei ein p-dotierter Zwischenbereich, der in lateraler Richtung zwischen diesen n-Zonen liegt, Teil der p-Verbindungszone 15 ist. Die einzelnen n-Zonen können in lateraler Richtung eine beliebige Geometrie aufweisen und können insbesondere streifenförmig ausgebildet sein. Die einzelnen n-Zonen sind dabei jeweils an ein eine n-Verbindungszone 32 angeschlossen. Zur Herstellung der in Figur 8B dargestellten Struktur wird der Halbleiterkörper während der Protonenimplantation mit einer gitterförmigen Maske maskiert.

Anstatt mehrere in lateraler Richtung beabstandete n-Zonen 31 herzustellen, besteht in nicht näher dargestellter Weise auch die Möglichkeit, eine durchgehende n-Zone 31 herzustellen, die in lateraler Richtung jedoch p-dotierte "Aussparungen" aufweist, die dann Teil der p-Verbindungszone sind. Eine solche Struktur kann erreicht werden, wenn der Halbleiterkörper 100 bei der Protonenbestrahlung an singulären Stellen abgedeckt wird.

Die Herstellung der vergrabenen n-Halbleiterzonen 31 erfolgt bei dem zuvor anhand der Figuren 6A bis DF erläuterten Verfahren vorzugsweise derart, dass der gegenseitige Abstand zweier in vertikaler Richtung benachbart zueinander angeordneter Halbleiterzonen 31 geringer ist als die Diffusionslänge von Minoritätsladungsträgern in den die Grunddotierung aufweisenden Abschnitten 12 des Halbleiterkörpers und vorzugsweise geringer als das 0,25-fache der Diffusionslänge. Gleiches gilt auch für den lateralen Abstand zweier n-Zonen, wenn in einer parallel zu den ersten und zweiten Seiten 101, 102 verlaufenden Ebene mehrere solcher n-Zonen 31 realisiert werden.

Mittels des erfindungsgemäßen Verfahrens lassen sich in vertikaler Richtung schmale n-dotierte Halbleiterzonen 31 an vergleichsweise exakt vorgebbaren Positionen innerhalb des Halbleiterkörpers 100 erzeugen, wodurch insgesamt ein pn-Übergang mit einer großen Fläche innerhalb eines gegebenen Volumens des Halbleiterkörpers 100 erreicht werden kann. Hieraus resultiert eine geringere Entfernung, die durch Licht erzeugte freie Ladungsträger in der Solarzelle zurücklegen müssen bis sie eine Raumladungszone erreichen, und dadurch eine erhöhte Stromergiebigkeit der Solarzelle.

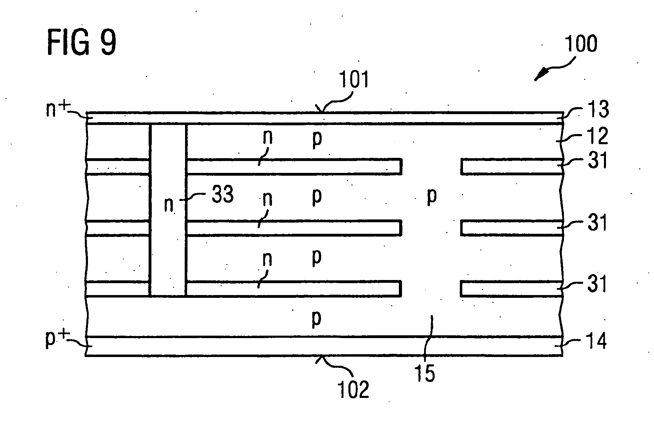

Die Herstellung einer die vergrabenen n-dotierten Halbleiterzonen 31 an den n-Emitter 13 anschließenden Verbindungszone 33 kann entsprechend der Herstellung der in Figur 1G dargestellten n-Halbleiterzonen 11 dadurch erfolgen, dass Protonen maskiert über die erste Seite 101 in den Halbleiterkörper implantiert werden und dass sich an diese Protonenimplantation ein Ausheilschritt zur Erzeugung wasserstoffinduzierter Donatoren anschließt. Eine Solarzelle mit einer derart hergestellten Verbindungszone 33 ist in Figur 9 im Querschnitt dargestellt.

Diese Verbindungszone 33 kann vor der Herstellung der in lateraler Richtung verlaufenden n-Zonen 31 oder nach deren Herstellung erfolgen.

Für eine Herstellung der Verbindungszone nach Herstellung der n-Zonen sind mehrere Implantationsschritte mit unterschiedlichen Implantationsenergien erforderlich. Die Implantationsenergien sind dabei so zu wählen, dass Protonen in die p-Bereiche 12 zwischen jeweils zwei in vertikaler Richtung beabstandet angeordnete n-Zonen 31 gelangen, um nach Durchführung eines Ausheilschrittes dort eine n-Dotierung zu bewirken. Ein Teil der n-Verbindungszone 33 entsteht bei Herstellung der n-Zonen 31. Selbstverständlich können die Implantationsschritte zur Herstellung der n-Zonen 31 und der Verbindungszone 33 auch abwechselnd durchgeführt werden.

Für eine Herstellung der n-Verbindungszone 33 vor Herstellung der n-Zonen 31 kann ein Implantationsschritt genügen, wenn die Temperatur und/oder die Dauer des vor der Herstellung der n-Zonen 31 durchgeführten Ausheilschrittes so gewählt sind, dass die implantierten Protonen in erheblichem Umfang in Richtung der Bestrahlungsseite 101 diffundieren, so dass ein n-dotierter Bereich über den gesamten Bestrahlungsschäden aufweisenden Bereich entsteht. Die Herstellung der Verbindungszone 33 kann nach Herstellung der n-Zonen 31 nicht durch nur einen Implantationsschritt erfolgen, da die erforderliche Ausheiltemperatur und/oder die erforderliche Ausheildauer zu einem "Zusammenwachsen" der n-Zonen 31 in vertikaler Richtung führen würden.

Bei dem in Figur 9 dargestellten Bauelement sind die n-Zonen unter Verwendung einer maskierten Protonenbestrahlung hergestellt, so dass eine die p-Grunddotierung des Halbleiterkörpers 100 aufweisende p-Verbindungszone 15 vorhanden ist, die die p-Zwischenzonen 12 an den p-Emitter anschließt. Bei dieser Solarzelle, erstrecken sich vergrabene n-dotierte Halbleiterzonen 31 in horizontaler Richtung ausgehend von der n-Verbindungszone 33 in den Halbleiterkörper hinein, während in vertikaler Richtung durchgehende p-dotierte Abschnitte 15 vorhanden sind, in denen keine vergrabenen n-dotierten Halbleiterzonen 31 vorhanden sind.

Selbstverständlich könnte eine p-Verbindungszone bei dem Bauelement gemäß Figur 9 auch entsprechend der p-Verbindungszone 32 in den Figuren 6A-6D realisiert werden.

Das zuvor erläuterte Verfahren zur Herstellung tief reichender oder vergrabener n-dotierter Halbleiterzonen in einem p-dotierten Halbleitersubstrat ist nicht auf die Herstellung von Solarzellen beschränkt, sondern ist beispielsweise auch auf die Herstellung von Strahlungsdetektoren anwendbar. Strahlungsdetektoren, die zur Detektion hochenergetischer Strahlung, beispielsweise Höhenstrahlung oder Gammastrahlung dienen, gleichen im Aufbau Solarzellen und weisen einen pn-Übergang auf, der - im Gegensatz zu Solarzellen - während des Betriebs durch Anlegen einer Spannung in Sperrrichtung vorgespannt wird. Diese Sperrspannung bewirkt die Ausdehnung einer Raumladungszone zu beiden Seiten des pn-Übergangs. Gelangen während des Betriebs Strahlungsteilchen in den Bereich der Raumladungszone, so werden Ladungsträgerpaare generiert, die einen Sperrstrom hervorrufen, der als Nachweis für Strahlungsteilchen dient.

Zur Erhöhung der Nachweisempfindlichkeit ist es bei Strahlungsdetektoren wünschenswert, dass sich die Raumladungszone bei einer gegebenen Sperrspannung möglichst weit bzw. tief in den Halbleiterkörper hinein erstreckt. Bei herkömmlichen Strahlungsdetektoren mit einem oberflächennahen pn-Übergang zwischen einem p-Substrat und einer höher dotierten n-Zone wird dies durch eine möglichst geringe Grunddotierung des Substrats erreicht. Eine niedrige Grunddotierung erhöht allerdings die Gefahr einer langfristigen Degradation bedingt durch Strahlungsschäden.

Bei einem mittels des erfindungsgemäßen Verfahrens hergestellten Strahlungsdetektors, der tiefe pn-Übergänge aufweist, ist bereits durch die Geometrie des pn-Übergangs sichergestellt, dass sich eine bei Anlegen einer Sperrspannung ausbreitende Raumladungszone tief in den Halbleiterkörper hinein erstreckt. Das p-Substrat kann daher höher dotiert werden als bei herkömmlichen Detektoren, so dass hierdurch und insbesondere aber auch aufgrund der tiefen vertikalen pn-Übergänge das Problem einer langfristigen Degradation bedingt durch Bestrahlungsschäden vermieden oder zumindest deutlich gemindert ist.

Zusammenfassend sind alle zuvor für Solarzellen erläuterten Herstellungsverfahren auch für die Herstellung von Strahlungsdetektoren geeignet, und alle zuvor für Solarzellen geeigneten Hauelementstrükturen eignen sich auch für Strahlungsdetektoren.

### Bezugszeichenliste

- 11': Defektbereiche
- 11: Halbleiterbereiche mit wasserstoffinduzierten Donatoren
- 12: Grunddotierung des Halbleiterkörpers aufweisende Bereiche
- 13: n-Emitter
- 14: p-Emitter
- 15: p-dotierte Zone
- 21, 22: Anschlusselektroden
- 31': Defektbereiche
- 31: Halbleiterbereiche mit wasserstoffinduzierten Donatoren
- 32: n-Verbindungszone
- 33: n-Verbindungszone
- 41: Füllmaterial.
- 100: Halbleiterkörper
- 101: erste Seite des Halbleiterkörpers
- 102: zweite Seite des Halbleiterkörpers
- 103: Graben des Halbleiterkörpers
- 201: Maske
- 202: Aussparungen der Maske

## Patentansprüche

1. Verfahren zur Herstellung einer Solarzelle oder eines Strahlungsdetektors, das die Verfahrensschritte aufweist:
- Bereitstellen eines einkristallinen Halbleiterkörpers (100), der zwei gegenüberliegende Seiten (101, 102) und eine p-Grunddotierung aufweist,
- Implantieren von Protonen mit Implantationsenergien zwischen 0,5 MeV und 10 MeV über eine erste (101) der Seiten derart in den Halbleiterkörper (100), dass eine Anzahl in einer lateralen Richtung des Halbleiterkörpers beabstandet zueinander angeordneter Defektbereiche (11') entsteht, die sich ausgehend von der einen Seite (101) in den Halbleiterkörper (100) hinein erstrecken,
- Durchführen eines Ausheilschrittes, bei dem der Halbleiterkörper wenigstens im Bereich der Defektbereiche (11') aufgeheizt wird und dessen Temperatur und Dauer derart gewählt sind, dass eine Anzahl beabstandet zueinander angeordneter n-dotierter Halbleiterzonen (11) entstehen"
- Herstellen eines n-dotierten Emitters (13), der sich an die n-dotierten Halbleiterzonen (11) anschließt und der höher als die n-dotierten Halbleiterzonen (11) dotiert ist im Bereich der ersten Seite (101).

2. Verfahren nach Anspruch 1, bei dem der n-dotierte Emitter (21) derart hergestellt wird, dass Abschnitte (12) des Halbleiterkörpers (100) mit einer p-Grunddotierung unmittelbar anschließend an die erste Seite (101) vorhanden sind.

3. Verfahren nach einem der vorangehenden Ansprüche, bei dem
- säulenförmige n-dotierte Halbleiterzonen (11) hergestellt werden; oder
- mehrere in lateraler Richtung des Halbleiterkörpers (100) parallel zueinander verlaufende n-dotierte Halbleiterzonen (11) hergestellt werden; oder
eine n-dotierte Halbleiterzone (11) hergestellt wird, die in einer parallel zu der ersten und zweiten Seite (101, 102) verlaufenden Ebene gitterförmig ausgebildet ist.

4. Verfahren nach einem der vorangehenden Ansprüche, bei dem die Protonen während des Implantationsschrittes unter einem Winkel von 90° bezogen auf die erste Seite (101) in den Halbleiterkörper (100) implantiert werden oder
bei dem die Protonen während des Implantationsschrittes unter einem Winkel kleiner als 90° und größer als 45° bezogen auf die erste Seite (101) in den Halbleiterkörper (100) implantiert werden.

5. Verfahren nach einem der vorangehenden Ansprüche, bei dem der Abstand zweier benachbart angeordneter Defektbereiche (11', 31') kleiner oder gleich der Diffusionslänge von Elektronen in einem die Grunddotierung aufweisenden Abschnitt (12) des Halbleiterkörpers (100) ist, oder
kleiner oder gleich der 0,25-fachen Diffusionslänge von Elektronen in einem die Grunddotierung aufweisenden Abschnitt (12) des Halbleiterkörpers (100) ist.

6. Verfahren nach einem der vorangehenden Ansprüche, bei dem in den Halbleiterkörper Störstellen eingebracht werden, die Energieniveaus bewirken, die in der Bandlücke des für den Halbleiterkörper verwendeten Halbleitermaterials liegen und die über Mehrfachstufenanregung die Effizienz der Solarzelle erhöhen.

7. Solarzelle oder Strahlungsdetektor mit folgenden Merkmalen:
- einen Halbleiterkörper mit einer ersten und einer zweiten Seite (101, 102), der eine p-Grunddotierung aufweist,
- eine n-dotierte erste Emitterzone (13),
- mehrere n-dotierte Halbleiterzonen (11), die in einer lateralen Richtung des Halbleiterkörpers (100) beabstandet zueinander angeordnet sind, die sich wenigstens teilweise in einer vertikalen Richtung in dem Halbleiterkörper (100) erstrecken, die sich an die erste Emitterzone (13) anschließen, die als durchgehende Zonen ausgebildet sind, die in lateraler Richtung jeweils zwischen zwei die Grunddotierung des Halbleiterkörpers (100) aufweisenden Abschnitten angeordnet sind, und die
- wasserstoffinduzierte Donatoren aufweisen,
- die erste Emitterzone (13) höher dotiert ist als die n-dotierten Halbleiterzonen (11)

8. Solarzelle oder Strahlungsdetektor nach Anspruch 7, bei der ein Abstand zweier benachbart angeordneter Halbleiterzonen (11) des zweiten Leitungstyps kleiner oder gleich der Diffusionslänge von Elektronen in einem die Grunddotierung aufweisenden Abschnitt (12) des Halbleiterkörpers (100) ist.

## Claims

1. Method for manufacturing a solar cell or a cadiation detector, having the following method steps:
- providing a monocrystalline semiconductor body (100) having two opposite sides (101, 102) and a p-type basic doping,
- implanting protons with implantation energies of between 0.5 MeV and 10 MeV into the semiconductor body (100) via a first one (101) of the sides in such a way that a number of defect regions (11') arranged at a distance from one another in a lateral direction of the semi conductor body arise which extend into the semiconductor body (100) proceeding from said one side (101),
- carrying out an annealing step in which the semiconductor body is heated at least in the region of the defect regions (11') and the temperature and duration of which are chosen such that a number of n-doped semiconductor zones (31) arranged at a distance from one another arise,
- producing an n-doped emitter (13) which is adjacent to the n-doped semiconductor zones (11) and which is doped more highly than the n-doped semiconductor zones (11) in the region of the first side (101).

2. Method according to Claim 1, wherein the n-doped emitter (21) is produced in such a way that sections (12) of the semiconductor body (100) having a p-type basic doping are present directly adjacent to the first side (101).

3. The method according to any of the preceding claims, wherein
- pillar-shaped n-doped semiconductor zones (11) are produced; or
- a plurality of n-doped semiconductor zones (11) running parallel to one another in a lateral direction of the semiconductor body (100) are produced; or
an n-doped semiconductor zone (11) is produced which is formed in lattice-shaped fashion in a plane running parallel to the first and second sides (101, 102).

4. Method according to any of the preceding claims, wherein the protons are implanted into the semiconductor body (100) at an angle of 90° relative to the first side (101) during the implantation step, or
wherein the protons are implanted into the semiconductor body (100) at an angle of less than 90° and greater than 45° relative to the first side (101) during the implantation step.

5. Method according to any of the preceding claims, wherein the distance between two defect regions (11', 31') arranged adjacent is less than or equal to the diffusion length of electrons in a section (12) of the semiconductor body (100) which has the basic doping, or
is less than or equal to 0.25 times the diffusion length of electrons in a section (12) of the semiconductor body (100) which has the basic doping.

6. Method according to any of the preceding claims, wherein impurities are introduced into the semiconductor body and bring about energy levels which lie in the band gap of the semiconductor material used for the semiconductor body and which increase the efficiency of the solar cell by means of multiple stage excitation.

7. Solar cell or radiation detector, having the following features:
- a semiconductor body having a first and a second side (101, 102), and having a p-type basic doping,
- an n-doped first emitter zone
- a plurality of n-doped semiconductor zones (11) which are arranged at a distance from one another in a lateral direction of the semiconductor body (100), which extend at least partly in a vertical direction in the semiconductor body (100), which are adjacent to the first emitter zone (13), are formed as continuous zones which are arranged in a lateral direction in each case between two sections having the basic doping of the semiconductor body (100), and which have hydrogen-induced donors, wherein
- the first emitter zone (13) is doped more highly than the n-doped semiconductor zones (11).

8. Solar cell or radiation detector according to Claim 7, wherein a distance between two semiconductor zones (11) of the second conduction type that are arranged adjacent is less than or equal to the diffusion length of electrons in a section (12) of the semiconductor body (100) that has the basic doping.

## Revendications

1. Procédé de fabrication d'une photopile ou d'un détecteur de rayonnement, qui comporte les stades de Procédé :
- on se procure un corps (100) semiconducteur monocristallin, qui a deux faces (101, 102) opposées et un dopage de base du type p,
- on implante des protons à des énergies d'implantation comprises entre 0,5 MeV et 10 MeV sur une première (101) des faces dans le corps (100) semiconducteur, de manière à créer un nombre de zones (11') de défauts, qui sont disposées à distance les unes des autres dans une direction latérale du corps semiconducteur et qui s'étendent en partant de la une face (101) à l'intérieur du corps (100) semiconducteur,
- on effectue un stade de recuit, dans lequel on chauffe le corps semiconducteur, au moins dans la partie des zones (11') de défauts, et on en choisit la température et la durée, de manière à créer un nombre de zones (111) semiconductrices dopées du type n disposées à distance les unes des autres,
- on prépare un émetteur (13) à dopage de type n, qui se raccorde aux zones (11) semiconductrices à dopage du type n et qui est plus dopé que les zones (11) semiconductrices à dopage du type n dans la zone de la première face (101).

2. Procédé suivant la revendication 1, dans lequel on fabrique l'émetteur (21) à dopage du type n par le fait qu'il y a des parties (12) du corps (100) semiconducteur ayant un dopage de base du type p se raccordant directement à la première face (101).

3. Procédé suivant l'une des revendications précédentes, dans lequel
- on fabrique des zones (11) semiconductrices à dopage du type n en forme de colonnes ; ou
- on fabrique plusieurs zones (11) semiconductrices à dopage du type n s'étendant parallèlement les unes aux autres dans la direction latérale du corps (100) semiconducteur ; ou
- on fabrique une zone (11) semiconductrice à dopage du type n, qui est en forme de grille, dans un plan s'étendant parallèlement à la première et à la deuxième faces (101, 102).

4. Procédé suivant l'une des revendications précédentes, dans lequel on implante dans le corps (100) semiconducteur les protons pendant le stade d'implantation sous un angle de 90° rapporté à la première face (101) ou
dans lequel on implante dans le corps (100) semiconducteur les protons pendant le stade d'implantation sous un angle plus petit que 90° et plus grand que 45° rapporté à la première face (101).

5. Procédé suivant l'une des revendications précédentes, dans lequel la distance entre deux zones (11', 31') de défauts voisines est inférieure ou égale à la longueur de diffusion des électrons dans une partie (12), ayant le dopage de base, du corps (100) semiconducteur ou
inférieure ou égale 0,25 fois la longueur de diffusion des électrons dans une partie (12), ayant le dopage de base, du corps (100) semiconducteur.

6. Procédé suivant l'une des revendications précédentes, dans lequel on introduit dans le corps semiconducteur des défauts qui donnent des niveaux d'énergie, qui sont dans les bandes interdites du matériau semiconducteur utilisé pour le corps semiconducteur et qui augmentent l'efficacité de la photopile par une excitation en stade multiple.

7. Photopile ou détecteur de rayonnement ayant les caractéristiques suivantes :
- un corps semiconducteur ayant une première et une deuxième faces (101, 102), qui a un dopage de base du type p,
- une première zone (13) d'émetteur à dopage du type n,
- plusieurs zones (11) semiconductrices à dopage du type n, qui sont disposées à distance les unes des autres dans une direction latérale du corps (100) semiconducteur, qui s'étendent, au moins en partie, dans une direction verticale dans le corps (100) semiconducteur, qui se raccordent à la première zone (13) d'émetteur, qui sont constituées sous la forme de zones continues, qui sont disposées dans la direction latérale respectivement entre deux parties ayant le dopage de base du corps (100) semiconducteur, et qui
- comportent des donneurs induits par de l'hydrogène, dans lequel
- la première zone (13) d'émetteur est plus dopée que les zones (11) semiconductrices à dopage du type n.

8. Photopile ou détecteur de rayonnement suivant la revendication 7, dans lequel une distance entre deux zones (11) semiconductrices voisines du deuxième type de conductivité est inférieure ou égale à la longueur de diffusion des électrons dans une partie (12), ayant le dopage de base, du corps (100) semiconducteur.
